# EUROPEAN PATENT APPLICATION

(11) **EP 4 481 965 A1**
(43) Date of publication of application: **25.12.2024**
(21) Application number: 23180095.4
(22) Date of filing: 19.06.2023
(51) Int. Cl.: H01S 5/36, H01S 5/12, H01S 5/125, H01S 5/11, H01S 5/187, H01S 5/042, H01S 5/02, H01S 5/10, H01S 5/34

(54) **SOLID-STATE THIN-FILM LASERS WITH INTEGRATED RESONATORS**

(71) Applicant: Imec VZW, 3001 Leuven (BE)
(72) Inventor: GOLDBERG, Iakov, 3001 Leuven (BE); ELKHOULY, Karim, 3000 Leuven (BE); HEREMANS, Paul, 3000 Leuven (BE); GENOE, Jan, 3272 Testelt (BE); GEHLHAAR, Robert, 3020 Herent (BE); ANNAVARAPU, Nirav, 3000 Leuven (BE)
(74) Representative: Winger

(57) **Abstract**

A laser device, comprising:
a) a substrate (1);
b) at least a first in-plane resonator (2);
c) a first electrode (6);
d) a lasing gain medium (9); and
e) a second electrode (11);

wherein each resonator (2) comprises at least two solid materials (3, 4) having an electrical conductivity below 3 S/m, wherein two or more of the solid materials (3, 4) differ in their refractive indices, wherein the top surface of the first in-plane resonator (2) is planar and has a root mean square roughness below 5 nm, wherein the first resonator (2) is either
a) situated above the substrate (1), or
b) comprises a material of the substrate (1) as a first of the at least two solid materials (3, 4), and

wherein any further in-plane resonators (2'), if present, are situated above the substrate (1).

## Description

### Technical field of the invention

The present invention relates to solid-state thin-film lasers, and more specifically, to solid-state thin-film lasers with integrated resonators, and methods for their fabrication.

### Background of the invention

In recent years, solid-state thin-film lasers have garnered significant interest due to their potential applications in various fields, such as optical communication, sensing, and display technologies.

WO2021107083 discloses an innovative approach to integrating multiple optoelectronic devices on a single substrate. This is achieved by introducing an element comprising a substrate and at least two distinct optoelectronic devices monolithically fabricated on it. By utilizing organic materials, WO2021107083 overcomes certain limitations of traditional inorganic electronics, enabling the development of optically pumped organic solid-state lasers, organic semiconductor laser diodes, and organic light-emitting diodes with varying emission wavelengths. The document also describes a method for producing the element and an organic semiconductor laser diode structure.

According to WO2021107083, an organic semiconductor laser diode includes a distributed feedback (DFB) grating made of a single low refractive index material featuring a corrugated top surface. This DFB resonator is either situated directly above an Indium Tin Oxide (ITO) electrode or directly above the substrate and embedded within the ITO electrode. In the latter case, the electrode deposited on the DFB grating has a thickness ranging from 70 to 100 nm. Although the document does not specify the depth of the periodic modulation in the thickness of the grating layer, it is typically within the range of 50-200 nm. Furthermore, WO2021107083 does not elaborate on the topography of the ITO electrode; however, we know that a 70-100 nm indium tin oxide (ITO) electrode layer is deposited on top of a DFB grating.

Depositing a 70-100 nm ITO electrode on the high-aspect-ratio features of a DFB grating presents significant challenges due to the limitations of existing deposition methods. Conformal deposition can be difficult to achieve, resulting in non-uniform layer thickness across the device. This is associated with a risk of electrical leakage, strong local electric fields, and optical losses by scattering. Devices with thickness-modulated layers are prone to less homogeneous vertical current injection. Consequently, when the bottom electrode layer is non-uniform, thickness modulation propagates into the following functional layers of the device. It leads to an uneven current profile through the lasing layers, causing unpredictable gain distribution across the active lasing medium. This situation may create multiple lasing modes that at least share partially the same volume and exhibit only slightly deviating radiation wavelengths, leading to undesirable and unstable switching between lasing modes.

Therefore, there is a need in the art for an improved solid-state thin-film laser architecture that can at least partially address one or more of these limitations.

### Summary of the invention

It is an object of the present invention to provide good electrically-operable laser devices.

The above objective is accomplished by a method and device according to the present invention.

In a first aspect, the invention relates to an electrically-operable laser device for emitting light at least at a wavelength λ. The device comprises a substrate, at least an in-plane resonator, a first electrode situated above the in-plane resonator, a lasing gain medium for emitting photons of at least at wavelength λ with a thickness of at most twice λ situated above the first electrode, and a second electrode situated above the lasing gain medium. The in-plane resonator comprises at least two solid materials, each having an electrical conductivity below 3 S/m at 20 °C, wherein two or more of the at least two solid materials differ in their refractive indices, wherein the surface of the in-plane resonator facing away from the substrate is planar and has a root mean square roughness below 5 nm, wherein the first resonator (2) is either
a) situated above the substrate (1), or
b) comprises a material from the substrate (1) as a first of the at least two solid materials (3, 4), and
wherein any further in-plane resonators (2'), if present, are situated above the substrate (1).

This is advantageous because it provides a smooth surface for the subsequent deposition of the individual layers that form the laser device stack, enabling improved optical performance and a more uniform vertical current injection.

In a second aspect, the invention relates to a method for manufacturing an electrically-operable laser device for emitting light at least at a wavelength λ, the method comprising the steps of:
a) providing a substrate (1);
b) forming at least a first in-plane resonator (2), each comprising at least two solid materials (3, 4), each having an electrical conductivity below 3 S/m at 20 °C, wherein the first in-plane resonator (2) is either positioned above the substrate (1) or comprises a material of the substrate (1) as a first of the at least two solid materials (3, 4), wherein any further in-plane resonators (2'), if present, are formed above the substrate (1);
c) depositing a first electrode (6) above the at least a first in-plane resonator (2);
d) providing above the first electrode (6) a lasing gain medium (9) for emitting photons of at least wavelength λ, said lasing gain medium (9) having a thickness of at most twice λ;
e) depositing a second electrode (11) above the lasing gain medium (9), wherein two or more of the at least two solid materials differ in their refractive indices, wherein the top surface of each of the at least a first in-plane resonator, said top surface facing away from the substrate, is planar and has a root mean square roughness below 5 nm.

### Brief description of the drawings

Fig. 1 is a vertical cross-section through schematic representations of two embodiments of the electrically-operable laser device of the present invention, including a top view of a resonator unit cell.
Figs. 2 to 6 are vertical cross-sections through schematic representations of a bottom part of further embodiments of the electrically-operable laser device of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third, and the like in the description and in the claims, are used for distinguishing between similar elements and not necessarily for describing a sequence, either temporally, spatially, in ranking, or in any other manner. It is to be understood that the terms so used are interchangeable under appropriate circumstances and that the embodiments of the invention described herein are capable of operation in other sequences than described or illustrated herein.

Moreover, the terms top, bottom, over, under, above, below, and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

The terms "over" and "above" are used as synonyms and cover situations with and without physical contact. The term "on" means "over and in physical contact with".

It is to be noticed that the term "comprising", used in the claims, should not be interpreted as being restricted to the means listed thereafter; it does not exclude other elements or steps. It is thus to be interpreted as specifying the presence of the stated features, integers, steps, or components as referred to, but does not preclude the presence or addition of one or more other features, integers, steps or components, or groups thereof. The term "comprising" therefore covers the situation where only the stated features are present (and can therefore always be replaced by "consisting of" in order to restrict the scope to said stated features) and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure, or characteristic described in connection with the embodiment is included in at least one embodiment of the present invention. Hence, occurrences of the terms "in one embodiment" or "in an embodiment" found throughout this document do not necessarily pertain to a single embodiment, but could be used to describe different embodiments. Furthermore, the particular features, structures, or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures, and techniques have not been shown in detail in order not to obscure an understanding of this description.

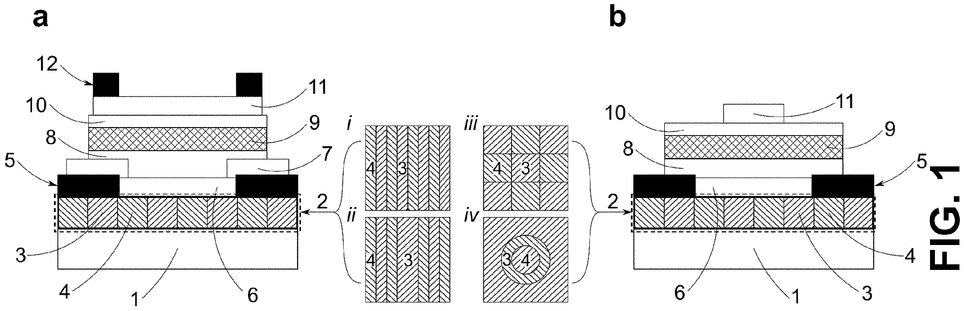

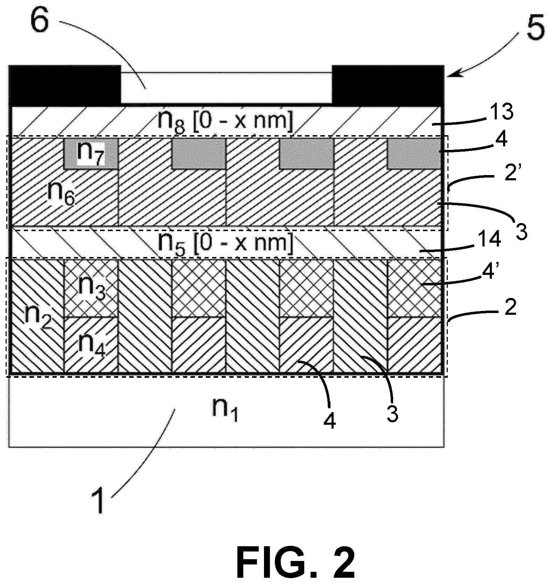

In a first aspect, embodiments of which being depicted in Figs. 1a and 1b, and partly depicted in Figs. 2 to 4, the invention relates to an electrically-operable laser device for emitting light at least at a wavelength λ. The device comprises a substrate (1), at least a first in-plane resonator (2) comprising at least two solid materials (3, 4, 4') which is either a) situated above the substrate (1), or b) comprises a material of the substrate (1) as a first (3) of the at least two solid materials (3, 4, 4'), a first electrode (6) situated above the at least a first in-plane resonator (2), a lasing gain medium (9) for emitting photons of at least wavelength λ with a thickness of at most twice λ situated above the first electrode (6), and a second electrode (11) situated above the lasing gain medium (9). The at least a first in-plane resonator (2) each comprises at least two solid materials (3, 4) having an electrical conductivity below 3 S/m at 20 °C, wherein two or more of the at least two solid materials (3, 4) differ in their refractive indices, with the surface of each of the at least a first in-plane resonator (2) facing away from the substrate (1) being planar and having a root mean square roughness below 5 nm. One of the first and second electrodes is the p-type electrode (anode) and the other electrode is the n-type electrode (cathode)

The electrical conductivities and the refractive indices mentioned in the present application are those found for the material, in bulk, in the literature.

In the context of the first aspect, "electrically-operable" refers to the ability of the laser device to be operated or be controlled by the application of an electrical current. Specifically, the laser device can be forward-biased, i.e., an external voltage can be applied across the laser device such that the voltage potential at the p-type electrode (anode) is higher than the voltage potential at the n-type electrode (cathode), with a power density of V×J, where V is the voltage and J is the current density. Upon application of sufficient current density, better known as a threshold current density, in a forward bias direction, spontaneous light emission generates stimulated emission that transforms into the output beam with lasing characteristics, which results in the emission of light primarily at the desired wavelength.

The laser device can be operated in either continuous mode (continuous wave) or pulsed mode, depending on the specific application requirements. In continuous mode, the device emits a beam of light of a constant optical power over time. Pulsed operation refers to any laser that is not operated as continuous wave and where optical power is emitted in pulses of some duration at some repetition rate. Both modes of operation are achieved by varying the electrical current applied to the laser device.

The electrically operable laser device is for emitting light at at least one wavelength λ.

In embodiments, it is for emitting light at a single wavelength having a spectral width of at most 10 nm, preferably at most 1 nm in full width at half maximum. In these embodiments, each of the at least a first in-plane resonator (2) is adapted to have a specific resonant mode or frequency that corresponds to the desired wavelength of the emitted light; and the lasing gain medium (9) in the device is also designed to emit photons at least at the same wavelength as the resonant mode of each of the at least a first in-plane resonators (2).

The present invention is also compatible with the emission of light at multiple wavelengths by using multiple gain media and/or by designing the at least a first in-plane resonator (2) to support multiple resonant modes. This can be achieved, for instance, by having a plurality of in-plane resonators (2, 2'), each designed to support a different resonant mode. Preferably, however, the laser device is for emitting light at a single wavelength.

The substrate (1) can be of any type; however, it is preferable to use a substrate (1) with a flat top surface, for instance, a top surface exhibiting a root mean square roughness below 5 nm. A flat top surface for the substrate (1) is advantageous because it makes it easier to form an in-plane resonator (2) with a flat surface facing away from the substrate (1). This ensures better thickness uniformity and overall performance of the device. A flat top surface for the substrate (1) allows for a more predictable deposition of the following functional device layers and better thickness control, leading to improved optical properties and better device electrical performance.

Moreover, having a flat top surface for the substrate (1) is beneficial for the manufacturing process. It simplifies the deposition and patterning of the various layers that constitute the device. This can lead to improved yield and lower production costs, as well as increased device reliability and longevity.

Furthermore, a substrate (1) with a flat top surface aids in the effective coupling of light into and out of the device. This ensures optimal light emission and contributes to a higher overall efficiency.

Lastly, a substrate (1) with a flat top surface does not form part of the first in-plane resonator (2), which liberates the in-plane resonator (2) from the necessity of employing the material that composes the top surface of the substrate as the first material (3) of the two or more of the at least two solid materials (3, 4).

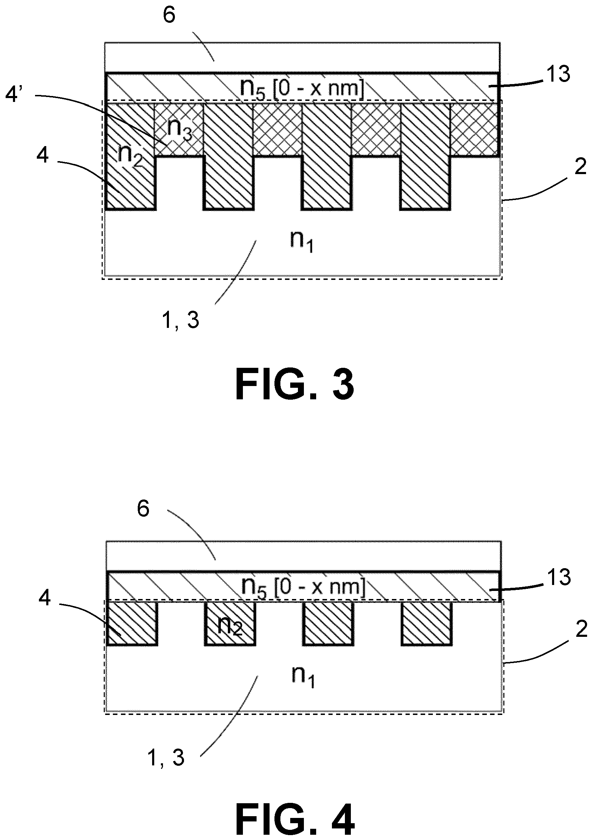

Nevertheless, the top surface of the substrate (1) does not need to be flat. The substrate (1) may be patterned or not. In particular, the top surface of the substrate (1) may exhibit a relief formed of at least one valley (16) and at least one peak (15) designed to provide the optical feedback favoring the amplification of light at the desired wavelength. See, for instance, the embodiment of Figs. 3, 4, and 6 described below. In other words, the first material (3) of the at least two solid materials (3, 4, 4') may be a material of the substrate, typically the material forming the top surface of the substrate (1).

In embodiments, the substrate (1) may have at least a 50%, preferably at least 80% transmittance, even more preferably at least 90% transmittance at λ. This is advantageous when bottom light emission is desired.

The laser device of the first aspect is compatible with a wide variety of substrates (1), providing versatility in its application. For instance, it can comprise a crystalline, polycrystalline, or amorphous substrate (1). It can also comprise either an organic or an inorganic substrate (1). Examples of suitable substrates (1) include, but are not limited to, glass, the backend-of-line (BEOL) of CMOS chips, Silicon photonic chips, and plastics such as PET, PEN, and polyimides.

Typically, the substrate is in physical contact with or is integral with the bottom surface of the in-plane resonator. Typically, any layer in physical contact with the bottom surface of the resonator is considered a part of the substrate.

The top layer of the substrate (1) has preferably an electrical conductivity below 3 S/m at 20 °C, preferably below 10⁻³ S/m, more preferably below 10⁻⁶ S/m. In other words, it is preferably electrically insulating, i.e., it is preferably made of a dielectric material.

An electrically insulating top layer helps to electrically isolate the electrical components from one another, such as electrodes and lasing gain medium (9). This prevents undesired current leakage and short circuits, ensuring proper functioning and increased reliability of the device. An electrically insulating top layer may also help to confine the electric field within the device structure, particularly between the electrodes and the lasing gain medium (9).

By isolating the electrically active layers of the device, the electrically insulating top layer also helps to minimize parasitic capacitance. This reduction in parasitic capacitance can lead to faster device response times, lower power consumption, and improved overall performance.

In embodiments, the substrate (1) may comprise a bottom part that is not electrically insulating, e.g., a bottom part having an electrical conductivity of at least 3 S/m, e.g., at least 500 S/m, and/or a bottom part which has a transmittance at λ below 50%. In such embodiments, the substrate (1) can comprise this bottom part, which can be a conductive or semiconductive bottom part and/or a bottom part which has a transmittance at λ below 50%, covered by an electrically insulating top layer, e.g., having an electrical conductivity below 3 S/m, preferably below 10⁻³ S/m, more preferably below 10⁻⁶ S/m (in other words, it is preferably electrically insulating, i.e., it is preferably made of a dielectric material), and having a transmittance at λ of at least 50% preferably at least 80%, more preferably at least 90%. The thickness of this top layer is preferably at least 1 µm, for instance from 1 µm to 2 µm. As an example, an electrically conductive substrate (1) (or any other substrate (1) without the desired transmittance), such as a silicon wafer with doping levels above 10¹² cm⁻³, can be covered by a layer of electrically insulating dielectric material (e.g., SiₓO_{y}, SiₓN_{y}, AlₓO_{y}, TiₓO_{y}, or other suitable materials).

Alternatively, the substrate (1) can be entirely electrically insulating with transmittance at λ of at least 50%, preferably at least 80%, even more preferably at least 90%. Examples of electrically insulating substrates (1) include quartz, glass, sapphire, polyimide, PEN, PET, and others.

The laser device of the present invention comprises at least a first in-plane resonator (2), i.e., an optical resonator that is adapted to confine, spatially localize, and guide light, and generate one or more lasing modes within a plane parallel to the substrate (1). It is a component of the laser device that allows light to be trapped and travel along the plane of the device, resulting in constructive interference and amplification of the light at the desired wavelength (λ).

The surface of each in-plane resonator (2) facing away from the substrate (1), that is, the top surface of each in-plane resonator (2) or (2'), is planar and possesses a root mean square roughness below 5 nm, preferably below 3 nm. Such a top surface can be achieved, for example, through a chemical mechanical planarization (CMP) process. Having a flat top surface for each of the in-plane resonators is beneficial because it enables the conformal deposition of subsequent layers, e.g., the first electrode layer, with uniform thickness. This leads to improved optical properties and better device electrical performances. Moreover, having a flat top surface for each in-plane resonator is beneficial for the manufacturing process. It simplifies the deposition and patterning of the various layers that constitute the upper layers of the device. This can lead to improved yield and lower production costs, as well as increased device reliability and longevity.

The root mean square roughness can, for instance, be estimated by analyzing a transmission (or scanning) electron microscopy image of a vertical cross-section through the laser device. The root mean square roughness values indicated herein are preferably directly measured by atomic force microscopy, e.g., on an intermediate structure exposing the layer to be measured during the fabrication of an electrically-operable laser device.

Devices featuring uniform layers experience low electrical leakage, lower optical scattering losses, and are better suited for prolonged electrical operation without irreversible degradation. Also, they exhibit more homogeneous vertical current injection. As a result, when the first electrode (6) layer has a uniform thickness, the following functional layers will typically conform to the smooth electrode surface, and no thickness modulation will propagate vertically in the device. It leads to a balanced current distribution throughout the lasing layers, producing homogeneous gain profiles. Such a uniform current profile contributes to stable device performance, ensuring optimal operation and improved reliability in various applications.

Typical single-material in-plane resonators of the prior art do not have a planar top surface. This is because the incorporation of a three-dimensional structure (a relief) is typically necessary to enable optical feedback. As used herein, a "relief' is a surface pattern or texture with variations in height. In other words, it is a topographic form of the material, which means it has raised and lowered areas, with the lowered areas being referred to as valleys and the higher areas being referred to as peaks. Examples of reliefs that can enable optical feedback are corrugations, i.e., a series of peaks and valleys which enables the desired optical feedback. Another example is a circular ridge core, also enabling the desired optical feedback in a ring resonator.

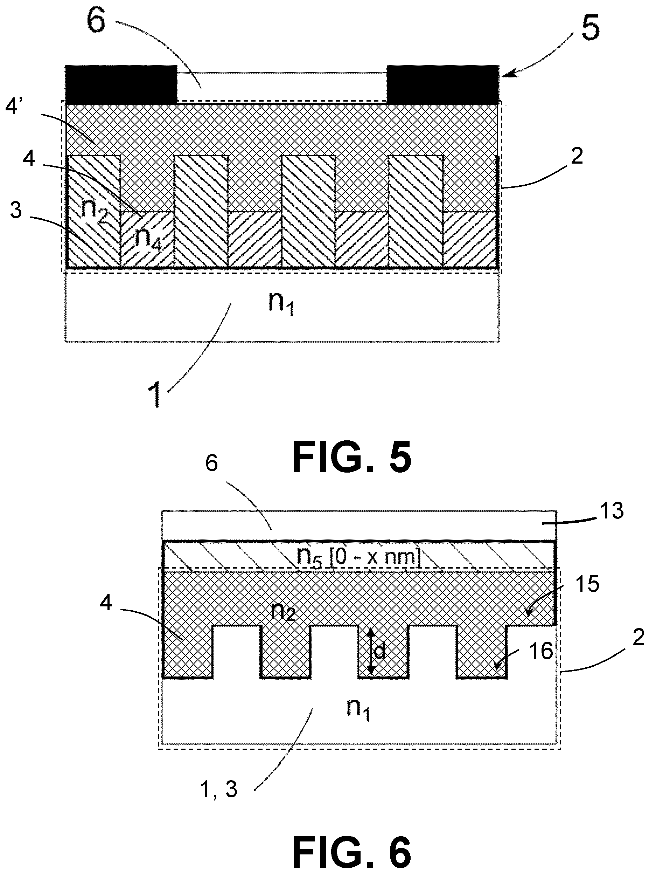

We now refer to Figs. 1-6. In the present invention, each of the at least a first in-plane resonator (2) is composed of at least two solid materials (3, 4), each having an electrical conductivity below 3 S/m at 20 °C. Two (3, 4) or more (4') of the at least two solid materials (3, 4) differ in their refractive indices. A first solid material (3) presents the necessary relief that enables light confinement and guidance within a plane parallel to the substrate (1). This relief is formed of at least one valley (16) and at least one peak (15) (see Fig. 6). This relief contributes to the optical feedback favoring the amplification of light at the desired wavelength. The depth (d) of the at least one valley (16) is selected so that the optical feedback favoring the amplification of light at the desired wavelength is provided. In embodiment, this depth (d) can be from 10 nm to 1000 nm, e.g., from 15 nm to 400 nm. At least a second material (4), having a different refractive index n₂ than the refractive index n₁ of the first solid material (3), fills in at least partially the at least one valley (16) within the relief. The second material (4) can partially fill the at least one valley (16) (see Fig. 2, (2) and Fig. 5); entirely fill the at least one valley (16) so as to have its top surface coplanar with the top surface of the first material (see Fig. 1, Fig. 2 (2'), and Fig. 4); overfill the at least one valley (16) so as to cover the peaks (15) of the first material (see Fig. 6), or overfill the at least one valley (16) so as to extend vertically beyond the peaks (15) of the first material, thereby creating new valleys (16) (see Fig. 3). In the first and last case, the in-plane resonator comprises one or more further materials (4'), completing the filling of the remaining valleys (16) either so as to have a top surface of one of the one or more further materials (4') coplanar with the top surface of the peaks (15) creating these valleys (16) (see Fig. 2 (2) and 3) or so as to overfill the remaining valleys (16) so as to cover the peaks (15) created by these remaining valleys (16) (see Fig. 5). Of course, if the further materials (4') themselves create further valleys (16), these will have to be filled with yet further materials (4'), and so on, until the top surface of one of the yet further materials is planar with a root mean square roughness below 5 nm. As discussed previously, a CMP or similar process can be utilized to achieve the said root mean square roughness. In short, each in-plane resonator (2, 2') can consist of, on one hand, the first (3) of the two or more of the at least two solid materials differing in their refractive indices, said first solid material (3) comprising the relief having the at least one valley (16), and on another hand, one or more further materials (4, 4') comprising the second (4) of the at least two solid materials differing in their refractive indices, said one or more further materials filling valleys (16) created by the first solid material (3) or by each other (4, 4') so as to form a planar top surface with a root mean square roughness below 5 nm for the in-plane resonator (2). In other words, each in-plane resonator (2) can consist of a first solid material (3) having a first refractive index, which forms a relief with at least one valley (16), and one or more further materials (4, 4') comprising the at least a second material (4), said one or more further materials (4, 4') filling the valleys (16) created by the first material (3) and, if present, further valleys (16) created due to the layering of said further materials (4, 4'). This includes instances where a second material (4) fills the valleys (16) of the first material (3) and extends vertically above its peaks (15), thereby creating new valleys (16) which can be filled by a third material (4') (see Fig. 3).

In the figures, the in-plane resonators (2, 2') are delimited by the dashed rectangles. The first material (3) refers to the lowest-lying material that contributes to the formation of the relief structure with the deepest valleys (16). If multiple materials exist at the same level (see Fig. 2 (2) and Fig. 5), then the one that forms the deepest valleys (16) is considered the first material (3). When both materials (3, 4) have valleys (16) having the same depth (d) (see Fig. 1, 2 (2'), and 5), any of both materials can be considered as the first solid material (3). Also, when more than one solid material fills the valleys (16) of the first material, the material that will fill the bottom of the valleys (16) will be considered the second solid material (4). This convention is arbitrary and is used for ease of description only. The resulting in-plane resonator (2) has a top surface that is either:
- composed only of the top surface of one of the second (4) and further (4') materials of the at least two solid materials as in Figs. 5 and 6, or
- composed of the top surface of two of the two or more of the at least two solid materials, wherein both top surfaces are coplanar, as in the other figures.

Preferably, the top surface of at least one, more preferably the highest-lying one, yet more preferably each of the at least a first resonator is composed of the top surface of two of the two or more of the at least two solid materials (e.g., composed of the top surface of the peaks (15) of the first material and the top surface of the second material), wherein both top surfaces are coplanar. In other words, the top surface of each of the at least a first resonator may consist of the top surface of two of the two or more of the at least two solid materials, wherein both top surfaces are coplanar. This is advantageous because it minimizes the distance between the first electrode (6) and the top surface of first material of the highest-lying (or only) in-plane resonator, creating light confinement and guidance within a plane parallel to the substrate (1). This short distance, which is zero if the first electrode (6) is in direct physical contact with the resonator, improves the interaction between the resonator and the photons generated by the gain medium.

In embodiments, the surface of at least one of the in-plane resonators (2), said surface facing away from the substrate (1), is in physical contact with a bottom surface of the first electrode (6).

Although not preferred, it is also possible to insert a layer (13), not belonging to the in-plane resonator (2), i.e., of a different material than any material forming the top surface of the in-plane resonator (2), between the in-plane resonator (2) and the first electrode (6).

When more than one in-plane resonator (2, 2') is present, it is possible to insert a layer (14) between any pair or in-plane resonator, not belonging to the top surface of the lowest-laying in-plane resonator (2) of the pair.

In embodiments, each of the at least two materials (3, 4, 4') may have an electrical conductivity below 10⁻³ S/m, preferably below 10⁻⁶ S/m at room temperature (20 °C). In other words, they are preferably electrically insulating, i.e., they are preferably made of a dielectric material. Using materials that are less conductive is advantageous because conductive materials introduce higher losses in the resonator due to absorption of the electromagnetic energy by free carriers. Using at least two different dielectric materials can lead to lower optical loss and a higher quality factor, resulting in better device performance and potentially lower lasing thresholds. Furthermore, dielectric materials have lower absorption and scattering losses compared to conductive materials. This can result in better confinement of light within the resonator, leading to a stronger resonant mode and improved overall performance.

In embodiments, the in-plane resonator (2) may consist of two solid materials. This can be advantageous because a resonator consisting of two different materials generally requires fewer processing steps compared to a resonator that incorporates three or more materials. This leads to reduced fabrication complexity, lower cost, and shorter production times. Also, in a resonator with fewer materials, there are fewer interfaces where light can be reflected or scattered, leading to lower loss and higher quality factor for the resonator. However, using more than two solid materials in the in-plane resonator (2) might offer some advantages in certain cases, such as an enhanced control over dispersion and confinement. Using one or more additional materials can provide more control over the dispersion and confinement properties of the in-plane resonator, enabling the tailoring of the device's optical properties for specific applications.

In embodiments, the two or more of the at least two solid materials (3, 4) differ in their refractive indices by at least 0.1, such as at least 0.3, or at least 0.5. A larger difference in refractive indices between the materials can lead to better light confinement, stronger resonant modes, higher Q-factors, and potentially lower lasing thresholds. The Q-factor is a dimensionless parameter that indicates the rate at which energy is lost relative to the stored energy of the resonator. A higher Q-factor indicates a lower rate of energy loss relative to the stored energy of the resonator; hence, the photon lifetime within the resonator is prolonged.

In embodiments, the at least two solid materials (3, 4) in the in-plane resonator (2) may alternate horizontally below the bottom surface of the first electrode (6).

The electrically-operable laser device may comprise one or more in-plane resonators (2) as described in the first aspect. When more than one in-plane resonator (2) is present, each in-plane resonator (2) forms a layer present at a different depth below the bottom surface of the first electrode (6). In embodiments, each in-plane resonator (2) as described in the first aspect may fall into one of four primary categories: i) 1D Periodic; ii) 1D Aperiodic; iii) 2D Periodic; iv) 2D Aperiodic, see Fig. 1. These in-plane resonators (2) may be the same or different, e.g., in lateral dimensions and shapes. Each in-plane resonator (2) within these categories is characterized by a distinct arrangement of at least two different solid materials (3, 4), in a 1D or 2D pattern. These said solid materials (3, 4) do not need to occupy equal volume in the resonator. This could involve the said at least two solid materials (3, 4) alternating in a regular (periodic) or irregular (aperiodic) pattern within an in-plane resonator (2). In embodiments, the pattern within an in-plane resonator (2) may exhibit symmetry, such as reflection, rotation, translation, glide reflection, scale, or circular symmetry. In embodiments, different in-plane resonators (2) can be separated by one or more uniform layers (14) of a material having an electrical conductivity below 3 S/m at 20 °C. Typically, no empty volume is present between in-plane resonators (2, 2'). When more than one in-plane resonator (2, 2') is present, the electrically-operable laser device typically comprises distinct in-plane resonators (2, 2') as defined above, optionally separated by one or more uniform layers (14) of a material having an electrical conductivity below 3 S/m at 20 °C. The overall arrangement of these in-plane resonators (2) within the laser device does not necessarily adhere to a periodic pattern.

In greater detail, four resonator architectures, which are each composed of the at least two solid materials (3, 4), are described with reference to Fig. 1:
i) 1D Periodic: In this arrangement, the at least two solid materials (3, 4) form a one-dimensional pattern that repeats at regular intervals along a line. The two or more solid materials (3, 4) can, for instance, exhibit translational symmetry, reflection (or bilateral) symmetry, and/or rotational symmetry.
   An application example of this configuration can be a 1D distributed feedback grating wherein the at least two different materials (3, 4) are organized periodically and comprise a material having a first refractive index (3) and a material having a second refractive index (4). This can help achieve wavelength tunability, single-mode operation, and better control of the laser emission properties. The grating operation is based on periodic reflections of the lasing mode within the grating structure.
   The in-plane resonator i of Fig. 1 is an example of a uniform-width periodic resonator where the materials are organized in a repeated pattern along a horizontal direction where all materials are cycled (e.g., they alternate in the case of two materials) and have the same width.
   Another example of a resonator (not depicted) is a constant-differential-width periodic grating where the materials are organized in a repeated pattern along a horizontal direction with a fixed distance between the same materials and with different widths for both materials.
ii) 1D Aperiodic: In this arrangement, the at least two different solid materials (3, 4) form a one-dimensional pattern that does not have a regular repeating structure along a line. While the pattern is not periodic, it can still have reflection and/or rotational symmetry. Examples of this arrangement could include irregular or complex line patterns of the at least two different solid materials (3, 4).
   1D aperiodic arrangement can be realized by incorporating a defect anywhere within the 1D periodic arrangement, thus eliminating the translational symmetry.
iii) An application example is a defect-based 1D distributed feedback grating with a phase shift incorporated in the grating, which supports a standing wave within the defect. The introduction of a phase shift in the grating creates a defect in the periodic structure, which enhances the coupling of light to a specific wavelength and suppresses other modes. This results in single-mode operation. Other suitable aperiodic arrangements are well-known to the person skilled in the art. 2D Periodic: In this arrangement, the at least two different solid materials (3, 4) form a two-dimensional pattern that repeats at regular intervals in a plane. The pattern can, for instance, exhibit translational symmetry, reflection symmetry, rotational symmetry, and/or glide reflection symmetry. Examples of this type of arrangement include square or rectangular grid patterns, and hexagonal lattice patterns, amongst others.
   Application examples are 2D distributed feedback grating with a square, hexagonal, or honeycomb lattice periodic arrangement, amongst others. In-plane resonator iii in Fig. 1 is an example of a uniform-width periodic index modulation where the materials are organized in a repeated pattern along two orthogonal horizontal directions wherein, in each horizontal direction, all materials are cycled (e.g., they alternate in the case of two materials) and have the same width.
iv) 2D Aperiodic: In this arrangement, the at least two solid materials (3, 4) form a two-dimensional pattern that does not have a regular repeating structure in a plane. The pattern can, for instance, exhibit circular symmetry or scale symmetry (self-similarity), or may have no symmetry at all.

In this case, the index contrast provided by the at least two solid resonator materials (3, 4) need not to alternate horizontally to create an optical cavity. Examples of this arrangement could include complex or irregular patterns, or patterns with circular or radial layouts like a "bull's eye", "ring" or "race track" arrangement. For instance, a peak (15) of the relief created by the first solid material (3) can form a loop-shaped waveguide while the second material (4) fills the valleys (16) within the relief. In other words, the relief can form a loop-shaped waveguide made of the first resonator material wherein the first resonator material is embedded into another resonator material. In this manner, a ring resonator or whispering gallery mode resonator can be achieved. In yet other words, the relief can be a higher refractive index ridge forming the waveguide core surrounded by a lower refractive index medium forming the waveguide cladding, composing a closed loop within the device plane. Thus, optical feedback is generated due to the interaction of counterpropagating modes. These are examples of an aperiodic arrangement of the at least two solid materials. Such resonators can support multiple high-quality-factor (Q-factor) resonant modes.

Another example of a 2D aperiodic arrangement could be a photonic crystal configured in a Penrose tiling pattern. This quasi-crystal, while ordered, does not exhibit periodicity. For instance, this 2D aperiodic arrangement can contain embedded defects, which are disruptions in the normal pattern. These defects can be introduced in such a way that the formation of an optical cavity results. This cavity, localized to the defect region, traps and controls light, which can then be manipulated for various applications.

A periodic 2D DFB arrangement can be broken by introducing a phase shift of about π/2 (e.g., π/2 ± 0.5 radians) or its multiples in the arrangement, turning it into a 2D aperiodic arrangement. For instance, the distributed feedback grating may be a defect-based distributed feedback grating incorporating a phase shift of π/2 ± 0.5 radians, or a multiple thereof, in the grating.

Other suitable periodic and aperiodic arrangements are well-known to the person skilled in the art.

Any other arrangement within an in-plane resonator that incorporates the at least two different solid dielectric materials (3, 4), in any form or sequence, within the entire resonator volume, each having an electrical conductivity below 3 S/m at 20 °C, wherein two or more of the at least two solid materials (3, 4) differ in their refractive indices, wherein the surface of the in-plane resonator (2) facing away from the substrate (1) is planar and has a root mean square roughness below 5 nm, also are in-plane resonators usable in any aspect of the present invention. The in-plane resonators described herein represent just a few exemplifications; the invention, however, encompasses also other possible embodiments and realizations within its scope, as long as the in-plane resonator (2) comprises at least two solid materials (3, 4), each having an electrical conductivity below 3 S/m at 20 °C, wherein two or more of the at least two solid materials (3, 4) differ in their refractive indices, wherein the surface of the in-plane resonator (2) facing away from the substrate (1) is planar and has a root mean square roughness below 5 nm.

In embodiments, each of the at least two different materials (3, 4) may have an extinction coefficient of less than 0.01 at the wavelength λ. The extinction coefficient is a measure of how much light is absorbed by a material at a specific wavelength. A low extinction coefficient indicates low absorption and, consequently, lower optical loss in the resonator. This can lead to higher Q-factor resonators, resulting in improved device performance and potentially lower lasing thresholds. Lower optical loss due to low extinction coefficients also results in less heat generation within the resonator, leading to better thermal stability and increased device lifetime.

In embodiments, the two or more solid materials (3, 4) of the in-plane resonator (2) may be selected from the group consisting of niobium oxides, silicon nitrides, silicon oxides, silicon oxynitrides, aluminum oxides, titanium oxides, Si, and Ge. This is advantageous because these materials have low absorption and scattering losses at specific wavelengths, contributing to lower optical loss in the resonator. This can result in higher Q-factor resonators and improved device performance. Also, these compounds generally exhibit good chemical and thermal stability.

In embodiments, the material having the first refractive index may occupy a volume fraction suitable for generating optical feedback. For instance, the volume fraction occupied by the first material may be from 35% to 65%, preferably 50% for first-order DFB gratings, and from 10% to 40%, preferably from 20 to 30% for second-order DFB gratings.

Preferably, the laser device of the present invention employs thin-film technologies for the formation of the lasing gain medium (9). The semiconductor properties of gain media formed by thin-film technologies are not reliant on tightly controlled growth processes templated by a crystalline substrate (1), as seen in III-V semiconductor layers. Instead, they can exhibit suitable semiconducting properties after their formation even on amorphous substrates (1).

In embodiments, the lasing gain medium (9) may comprise a material selected from the group consisting of, but not limited to: organic-inorganic metal halide perovskites, colloidal semiconductor nanocrystals, organic semiconductors, and chalcogenides.

Hybrid organic-inorganic metal halide perovskites are a class of semiconducting absorber/emitter materials that follow the ABX₃ crystal structure wherein A is a monovalent cation such as methylammonium (CH₃NH₃⁺), or formamidinium (HC(NH₂)₂⁺), or others, B is a bivalent cation such as Pb²⁺ or Sn²⁺, and X is an anion such as I⁻, Br⁻, or Cl⁻.

In certain embodiments, the lasing gain medium (9) may comprise a material selected from hybrid organic-inorganic metal halide perovskites having a grain size distribution with an average grain length larger than 500 nm. This is advantageous because this thin-film morphology is more suitable for high current density injection. Grain boundaries accumulate non-radiative defects and limit free carrier mobilities within the film. Moreover, grain boundary defects are susceptible to moisture- and heat-assisted degradation. As a result, large-grain morphology allows for high current density injection at much smaller electric fields across the gain layer, which translates into reduced Joule heating losses and weaker electric-field-induced quenching mechanisms.

Colloidal semiconductor nanocrystals refer to a class of nanoscale semiconductor materials that are dispersed in a solvent and form a colloidal solution. At least one dimension of these nanocrystals is equal to or smaller than the exciton Bohr radius of the nanocrystal material. Examples are quantum dots which are spherical or near-spherical nanoparticles with a diameter typically ranging from 2 to 10 nm which exhibit strong quantum confinement effects in all three dimensions; charged quantum dots, i.e., quantum dots with extra electrons or holes added to modify their electronic properties; and quantum wells, i.e., flat, two-dimensional nanostructures with a thickness typically ranging from 2 nm to 30 nm sandwiched between two other materials with a larger energy bandgap. They have strong quantum confinement in one dimension and free carrier motion in the other two dimensions. Other examples are nanoplatelets, i.e., thin, flat nanostructures with uniform thickness typically ranging from 1 to 10 nm, providing strong quantum confinement in one dimension; and nanorods, i.e., rod-shaped nanoparticles with confinement in two dimensions and free carrier motion in the third dimension, wherein the diameter of the shortest two dimensions of the rod typically measure from 1 to 100 nm. Typical material systems used for colloidal semiconductor nanocrystals include CdSe, CdS, PbS, PbSe, ZnS, ZnO, core-shell nanostructures like CdSe/ZnSe, and organic-inorganic metal halide perovskites nanocrystals.

Organic semiconductors are composed of organic molecules that feature a conjugated π (pi) system, which allows for the flow of electrical charge through the delocalization of electrons. These materials can be classified into two categories: polymers and small-molecule semiconductors. Polymers typically have a molecular weight greater than 1000 g/mol, while small-molecule semiconductors generally exhibit a molecular weight lower than 1000 g/mol.

Chalcogenides useful as a lasing gain medium (9) are semiconducting chalcogenide films having a thickness of up to 50 µm.

In embodiments, the lasing gain medium (9) may be constituted of layers having each an ambipolar carrier mobility of at least 10 cm²/V.s, preferably at least 50 cm²/V.s. This is advantageous because it allows the electrically-driven laser device to be scaled down to inject current densities above the lasing threshold, i.e., well above 100 A/cm², without irreversible lasing gain medium (9) degradation. Higher injected current densities beyond the lasing threshold allow for higher optical output power densities.

In embodiments, the thickness of the lasing gain medium (9) may be from 40 to 300 nm. This is advantageous because for thicker layers, the electrical series resistance becomes too large and there is destructive Joule heating when high current densities are injected. Joule heating induces run-away processes, reduction of optical efficiency, and permanent damage. Moreover, thicker gain layers can support multiple lasing modes, lowering device efficiency. Within this range, a thickness for the lasing gain medium (9) can typically be selected to allow for sufficient waveguiding in the lasing gain layer, maximizing net gain, and to guarantee good mode coupling to the underlaying integrated resonator.

In embodiments, the first electrode (6) may be a cathode or an anode, and the second electrode (11) may be an anode or a cathode, respectively.

In embodiments, the first electrode (6) may have both its bottom and top surfaces having a root mean square roughness below 15 nm, preferably below 10 nm, yet more preferably below 5 nm.

In embodiments, the first electrode (6) may be in physical contact with the lasing gain medium (9).

The first electrode (6) may have at least one region adjacent to the in-plane resonator (2) which has at least a 50%, preferably at least 80%, even more preferably at least 90% transmittance at λ. This is beneficial to reduce or supress all parasitic absorption mechanisms. It also facilitates mode coupling with the in-plane resonator (2).

For instance, the first electrode (6) may have a transmittance at λ of at least a 50%, preferably at least 80%, even more preferably at least 90%. For this purpose, the thickness and the chemical nature of the first electrode (6) may be adapted to reach said transmittance.

For instance, the thickness of the first electrode (6) may be from 1 to 40 nm, such as from 10 to 30 nm or from 15 to 25 nm. Apart from transmittance, a thickness of the bottom electrode within these ranges can be selected to facilitate good vertical current injection into the thin-film lasing layers. In contrast, thicker electrode layers even with optimized transmittance would reduce the optical mode coupling between the gain layer and the integrated resonator, and are, therefore, less preferred.

In embodiments, the first electrode (6) may be made of a transparent conductive oxide such as Indium Tin Oxide or Fluorine-doped Tin Oxide, Graphene, a conductive polymer such as poly(3,4-ethylenedioxythiophene) polystyrene sulfonate, or a mesh of metal nanowires. Preferably, it is made of a transparent conductive oxide.

The second electrode (11) may have at least one region adjacent to the in-plane resonator (2) which has at least 50%, preferably at least 80%, even more preferably at least 90% transmittance at λ. This is beneficial to reduce or suppress all parasitic absorption mechanisms.

For instance, the second electrode (11) may have a transmittance at λ of at least a 50%, preferably at least 80%, even more preferably at least 90%. For this purpose, the thickness and the chemical nature of the first electrode (6) may be adapted to reach said transmittance.

For instance, the thickness of the second electrode (11) may be from 1 to 100 nm, such as from 10 to 30 nm or from 15 to 25 nm.

In embodiments, the second electrode (11) may have both its bottom and top surfaces having a root mean square roughness below 15 nm, preferably below 10 nm, yet more preferably below 5 nm.

In embodiments, the second electrode (11) may be made of a transparent conductive oxide such as Indium Tin Oxide or Fluorine-doped Tin Oxide, Graphene, a conductive polymer such as poly(3,4-ethylenedioxythiophene) polystyrene sulfonate, or a mesh of metal nanowires. Preferably, it is made of a transparent conductive oxide.

In embodiments, the second electrode (11) may be in physical contact with the lasing gain medium (9).

In embodiments, the horizontal overlap between both electrodes may have an area of from 1 × 10⁻⁶ to 1 × 10⁻³ cm².

In embodiments, each of the substrate (1), the first electrode (6), the lasing gain medium (9), and the second electrode (11) may have both their bottom and top surfaces having a root mean square roughness below 15 nm, preferably below 10 nm, even more preferably below 5 nm.

Additional layers (8, 10) can be present between the lasing gain medium (9) and the first (6) and/or second electrode (11). Examples of such layers, in the case of p-i-n layer arrangement, i.e., when the first (bottom) electrode acts as an anode, are a hole transport layer (8) between the first electrode (6) and the lasing gain medium (9) and/or an electron transport layer (10) between the lasing gain medium (9) and the second electrode (11). Alternatively, in the case of n-i-p layer arrangement, i.e., when the first (bottom) electrode acts as a cathode, (8) represents an electron transport layer and (10) represents a hole transport layer. The use of transport layers, however, is not preferred.

In embodiments, any or all of the elements b) to e) may be selected so that they can be deposited at a temperature below 400 °C, preferably below 300 °C. This is advantageous because it makes such deposition compatible with back-end-of-line (BEOL) elements.

In embodiments, any or all of the elements b) to e) may be selected so that they can be deposited non-epitaxially by either a solution-based method or a vacuum method. This is advantageous because such methods are cost-effective and have a low thermal budget.

By "non-epitaxially", it is meant "in a way so that no long-range structural correlation exists between the deposited layer and the layer on which it is deposited. This implies that the deposition can take place on a surface that is amorphous or which has a different lattice constant than the deposited layer.

Examples of suitable solution-based methods are spin-coating, spray coating, and doctor blade coating, among others.

Examples of suitable vacuum methods are evaporation, sublimation, sputtering, among others.

In a second aspect, the invention relates to a method for manufacturing an electrically-operable laser device for emitting light at least at a wavelength λ, the method comprising the steps of:
a) providing a substrate (1);
b) forming an in-plane resonator (2) above the substrate (1);
c) depositing a first electrode (6) above the in-plane resonator (2);
d) providing above the first electrode (6) a lasing gain medium (9) for emitting photons of at least wavelength λ, said lasing gain medium (9) having a thickness of at most twice λ;
e) depositing a second electrode (11) situated above the lasing gain medium (9),
wherein the in-plane resonator (2) comprises at least two solid materials (3, 4), each having an electrical conductivity below 3 S/m at 20 °C, wherein two or more of the at least two solid materials (3, 4) differ in their refractive indices, wherein the surface of the in-plane resonator (2) facing away from the substrate (1) is planar and has a root mean square roughness below 5 nm.

In embodiments, the flat top surface of the in-plane resonator (2) may be formed by performing a planarization process, such as chemical mechanical polishing. This can provide a smooth surface for improved optical performance and efficient light emission.

In embodiments, any or all of steps b) to e) may be performed at a temperature below 400°C, preferably below 300°C. This is advantageous because it makes such deposition compatible with back-end-of-line elements.

In embodiments, any or all of steps b) to e) may be performed using non-epitaxial methods such as a solution-based method or a vacuum method. This is advantageous because such methods are cost-effective and have a low thermal budget. Any feature of the second aspect can be as correspondingly described in the first aspect.

In a third aspect, the present invention relates to the use of the electrically-drivable thin-film laser device according to any embodiment of the first aspect to emit laser radiation while operating at a temperature below -150 °C, preferably below -100 °C, more preferably below -50 °C, even more preferably at 20 °C.

### Example 1 (not depicted):

In a BEOL cleanroom, a pre-cleaned p-type doped to 10¹⁶ cm⁻³ (100) Si wafer (bottom part of the substrate, 1) is thermally oxidized in a horizontal furnace to grow 2000 nm of stochiometric SiO₂ (top part of the substrate, 1). A first resonator dielectric material (3), 200 nm of SiₓN_{y}, is deposited via low-pressure chemical vapor deposition (CVD). The SiₓN_{y} surface is subsequently coated with photosensitive film using a spin coater for the photoresist application, followed by a deep ultraviolet 193 nm exposure in a commercial stepper lithography equipment loaded with a photomask containing desired features. Upon exposure, the resist-coated wafer is immersed in a photoresist developer solution and UV-exposed areas are removed. Then, the grating patterns are transferred into the unprotected SiₓN_{y} areas by means of deep dry etching to obtain nearly vertical 200 nm-deep features. The photoresist is stripped, and the wafer is prepared for another plasma-enhanced CVD (PECVD) of the second (4) and third grating dielectric layers. 100 nm of Siₓ₁O_{y1} (4) is deposited into the valleys (16) of the SiₓN_{y} (3) relief and above the SiₓN_{y} relief peaks (15), thus forming a nearly 100 nm-thick Siₓ₁O_{y1} layer both above the SiₓN_{y} valleys (16) and peaks (15). Then, 300 nm of a third dielectric layer, Siₓ₂O_{y2}, with a different stoichiometry and refractive index from Siₓ₁O_{y1}, is grown in the same equipment but using different deposition conditions. The DFB resonator (2) is then planarized using chemical mechanical polishing (CMP) equipment to remove the planar overgrown Siₓ₁O_{y1}-Siₓ₂O_{y2} layer which is ≈ 200 nm thick. The process is continued until the index-modulated planarized SiₓN_{y}/Siₓ₂O_{y2} DFB interface is reached. The root mean square roughness of the resonator structure (2) top surface is below 5 nm.

50 nm Ti/Al/Ti or any other appropriate BEOL-compatible metal stack (5) with a sheet resistance below 5 Ohm/square is deposited via physical vapor deposition (PVD). The contact pads separated by 100 µm are defined by photolithography and wet etching processes. The resist is stripped and Indium Tin Oxide (ITO, 6) is deposited by direct-current magnetron sputtering. A Siₓ₃O_{y3} dielectric layer (7) is deposited on top of the ITO electrode (6) using a PECVD system and patterned using conventional photolithographic methods involving spin coaters for photoresist application, mask aligners for UV light exposure, and developer solutions for resist patterning. An opening is then created in the dielectric layer on top of the ITO electrode (6) using SF₆-based inductively coupled plasma, defining the active area for the device. The wafer (1) with integrated grating (2) and defined first ITO electrode (6) is then diced in smaller square dies, each 30 × 30 mm².

A perovskite active layer (9) is deposited from solution directly on the dielectric layer (7) and on the first electrode (6) in the active area using a spin coater or doctor-blading, depending on the viscosity of the solution. The solvent chosen for the perovskite is such that it does not dissolve the first electrode (6).

A second Indium Tin Oxide electrode layer (11) is deposited directly on top of the perovskite layer (9) using the same sputtering equipment as for the first ITO electrode (6) via an appropriate shadow mask. Optional Al contact pads (12) with a sheet resistance below 5 Ohm/square are vacuum-evaporated sufficiently far away from the device active area via an appropriate shadow mask.

### Example 2:

We now refer to Fig. 1a. Example 1 is repeated except that a hole/electron transport layer (8) is deposited on top of the first ITO electrode (6) and the dielectric layer (7) using a suitable deposition method, such as spin coating or doctor-blading, depending on the material used, that the perovskite active layer (9) is deposited from solution directly on the hole/electron transport layer (8), that an electron/hole transport layer (10) is deposited on top of the lasing gain medium (9) using a similar deposition method as for the hole/electron transport layer (8), and that the second ITO electrode layer (11) is deposited directly on top of the electron/hole transport layer (10) using the same sputtering equipment as for the first ITO electrode (6) via an appropriate shadow mask.

### Example 3:

We now refer to Fig. 1b. In a cleanroom, a clean Czochralski grown sapphire substrate (Al₂O₃, 1) with a c-plane (0001) surface orientation is provided in a thermal evaporation system. Before forming the first electrode (6), a whispering gallery mode (WGM) resonator (2) is created. To create the WGM resonator (2), a first 100 nm-thick dielectric layer (3) is deposited on the glass substrate via low pressure chemical vapor deposition (LPCVD). This dielectric layer (3) is subsequently coated with photosensitive film using a spin coater for the photoresist application, followed by a deep ultraviolet 193 nm exposure in a commercial stepper lithography equipment loaded with a photomask containing desired features. Upon exposure, the resist-coated sapphire wafer (1) is immersed in a photoresist developer solution and UV-exposed areas are removed. Then, the ring-shaped pattern is transferred into the unprotected dielectric areas by means of deep dry etching to obtain nearly vertical 100 nm-deep features, forming a ring resonator or WGM resonator. The photoresist is stripped, and the wafer is prepared for another CVD of the second dielectric layer (4). 200 nm of the second dielectric layer (4) with a different refractive index is deposited into the valleys (16) and above the first dielectric layer (3) peaks (15), thus forming a nearly 100 nm-thick second dielectric planar layer (4) above the integrated WGM resonator. The WGM resonator is then planarized using chemical mechanical polishing (CMP) equipment to remove the planar overgrown second dielectric layer which is ≈ 100 nm thick. The process is continued until the WGM (2) planarized interface is reached. The root mean square roughness of the resonator (2) structure top surface is below 5 nm.

Cu contact pads (5) with a thickness of 100 nm and separated by 200 µm are formed on the sapphire substrate (1) by depositing layers of Cu using an electron-beam evaporator, followed by patterning with photolithography and wet etching processes. A 10 nm Ag layer (6) is deposited by thermal evaporation using a resistive evaporator and patterned using lithography and lift-off methods onto the substrate, serving as the first electrode. The Ag is aligned carefully over the WGM structure to ensure a favorable coupling of a lasing mode to the WGM resonator.

A hole/electron transport layer (8) is deposited on top of the first Ag electrode (6) using a suitable deposition method, such as spin coating or doctor-blading, depending on the material used. The lasing gain medium (9), which could be a perovskite or an organic material, is then deposited on top of the hole/electron transport layer (8) using spin coating, doctor-blading, or vacuum evaporation, followed by annealing in an oven or on a hot plate, if required. The electron/hole transport layer (10) is deposited on top of the lasing gain medium (9) using a similar deposition method as for the hole/electron transport layer (8). A second 15 nm Ag layer is deposited as the second electrode (11) using the same resistive evaporator as for the first Ag electrode (6) via an appropriate shadow mask.

The active area of the device is defined by the overlap of the injection electrodes. Optional Au contact pads with a sheet resistance below 5 Ohm/square are vacuum-evaporated sufficiently away from the device active area via an appropriate shadow mask. In this modified protocol, no dielectric (7) is used to define the active area, and the lasing gain medium/organic layers do not need to be patterned.

It is to be understood that although preferred embodiments, specific constructions and configurations, as well as materials, have been discussed herein for devices according to the present invention, various changes or modifications in form and detail may be made without departing from the scope of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. An electrically-operable laser device for emitting light at least at a wavelength λ, comprising:
a) a substrate (1);
b) at least a first in-plane resonator (2);
c) a first electrode (6) situated above the at least a first in-plane resonator (2);
d) a lasing gain medium (9) for emitting photons of at least wavelength λ, said lasing gain medium (9) having a thickness of at most twice the wavelength λ and being situated above the first electrode (6); and
e) a second electrode (11) situated above the lasing gain medium (9), wherein each of the at least a first in-plane resonator (2) comprises at least two solid materials (3, 4, 4'), each having an electrical conductivity below 3 S/m at 20 °C, wherein two (3, 4) or more of the at least two solid materials (3, 4, 4') differ in their refractive indices, wherein the top surface of each of the at least a first in-plane resonator (2), said top surface facing away from the substrate (1), is planar and has a root mean square roughness below 5 nm,
wherein the first resonator (2) is either
a) situated above the substrate (1), or
b) comprises a material of the substrate (1) as a first (3) of the at least two solid materials (3, 4, 4'), and
wherein any further in-plane resonators (2'), if present, are situated above the substrate (1).

2. The electrically-operable laser device according to claim 1, wherein the at least two solid materials (3, 4) alternate horizontally.

3. The electrically-operable laser device according to claim 1 or claim 2, wherein each of the at least two solid materials (3, 4) has an extinction coefficient of less than 0.01 at the wavelength λ.

4. The electrically-operable laser device according to any one of the preceding claims, wherein a first of the at least two solid materials (3, 4) has a top surface presenting a relief comprising at least one valley (16) and at least one peak (15), and wherein a second of the at least two solid materials (3, 4) fills in at least partially the at least one valley (16).

5. The electrically-operable laser device according to any one of the preceding claims, wherein the surface of the in-plane resonator (2), facing away from the substrate (1), consists of said at least two solid materials (3, 4) being coplanar with each other.

6. The electrically-operable laser device according to any one of the preceding claims, wherein the surface of the first in-plane resonator (2) facing away from the substrate (1) is in physical contact with a bottom surface of the first electrode (6).

7. The electrically-operable laser device according to any one of the preceding claims, wherein the in-plane resonator (2) comprises a distributed feedback grating wherein the two or more of the at least two solid materials (3, 4) comprise a material having a first refractive index and a material having a second refractive index, wherein:
- the material having the first refractive index occupies 10 to 40% of the total grating volume, and/or
- the distributed feedback grating is a defect-based distributed feedback grating incorporating a phase shift within a tolerance of ±0.5 radians around π/2 or its multiples in the grating.

8. The electrically-operable laser device according to any one of the preceding claims, wherein the lasing gain medium (9) comprises a material selected from the group consisting of: hybrid organic-inorganic metal halide perovskites, colloidal semiconductor nanocrystals, organic semiconductors, and chalcogenides.

9. The electrically-operable laser device according to claim 8, wherein the lasing gain medium (9) comprises a material selected from organic-inorganic metal halide perovskites having a grain size distribution with an average grain length larger than 500 nm.

10. The electrically-operable laser device according to any one of the preceding claims, wherein the lasing gain medium (9) is constituted of layers having each an ambipolar carrier mobility of at least 10 cm²/V.s, preferably at least 50 cm²/V.s.

11. The electrically-operable laser device according to any one of the preceding claims, wherein the first electrode (6) has at least one region adjacent to the in-plane resonator (2) which has at least a 50%, preferably at least 80% transmittance, even more preferably at least 90% transmittance at the wavelength λ.

12. The electrically-operable laser device according to any one of the preceding claims wherein each of the substrate (1), the first electrode (6), the lasing gain medium (9), and the second electrode (11), have both their bottom and top surfaces having a root mean square roughness below 15 nm.

13. A method for manufacturing an electrically-operable laser device for emitting light at least at a wavelength λ, the method comprising the steps of:
a) providing a substrate (1);
b) forming at least a first in-plane resonator (2), each comprising at least two solid materials (3, 4), each having an electrical conductivity below 3 S/m at 20 °C, wherein the first in-plane resonator (2) is either positioned above the substrate (1) or comprises a material of the substrate (1) as a first (3) of the at least two solid materials (3, 4), wherein any further in-plane resonators (2'), if present, are formed above the substrate (1);
c) depositing a first electrode (6) above the at least a first in-plane resonator (2);
d) providing above the first electrode (6) a lasing gain medium (9) for emitting photons of at least wavelength λ, said lasing gain medium (9) having a thickness of at most twice λ;
e) depositing a second electrode (11) above the lasing gain medium (9), wherein two or more of the at least two solid materials differ in their refractive indices, wherein the top surface of each of the at least a first in-plane resonator, said top surface facing away from the substrate, is planar and has a root mean square roughness below 5 nm.

14. The method according to claim 13, wherein the planar top surface of the in-plane resonator (2) is formed by performing a planarization process.

15. The method according to claim 14, wherein the planarization process is a chemical-mechanical polishing.
